Europäisches Patentamt
European Patent Office
Office européen des brevets

(19)

(11) Numéro de publication: **0 093 672**
**A2**

(12)

# DEMANDE DE BREVET EUROPEEN

(21) Numéro de dépôt: 83400881.5

(22) Date de dépôt: 03.05.83

(51) Int. Cl.³: **H 01 L 31/18**
H 01 L 31/02

(30) Priorité: 03.05.82 DE 3216387

(43) Date de publication de la demande:
09.11.83 Bulletin 83/45

(84) Etats contractants désignés:
AT BE CH DE FR GB IT LI LU NL SE

(71) Demandeur: SAINT-GOBAIN VITRAGE
Les Miroirs 18, avenue d'Alsace
F-92400 Courbevoie(FR)

(72) Inventeur: Kessler, Franz Rudolf
Am Walde 42
D-3300 Braunschweig(DE)

(72) Inventeur: Dettmer, Klaus
Bültenweg 93 a
D-3300 Braunschweig(DE)

(72) Inventeur: Ritters, Ernst-Wilhelm
Rebenring 63/W 30713
D-3300 Braunschweig(DE)

(74) Mandataire: de Toytot, Robert et al,
SAINT-GOBAIN RECHERCHE 39 quai Lucien Lefranc
F-93300 Aubervilliers(FR)

(54) **Dépôt sur un substrat d'une couche semi-conductrice dopée afin de constituer une couche à réflexion sélective.**

(57) L'invention a trait à la formation de couches à réflexion sélective, dont le facteur de réflexion passe brutalement d'une valeur faible à une valeur élevée (courbe 41), cette formation ayant lieu par évaporation thermique ou pulvérisation cathodique sous un vide poussé, sur un substrat préchauffé, d'un semi-conducteur et d'un dopant dans des proportions en poids comprises entre 5/1 et 2/1.

On effectue l'évaporation ou la pulvérisation dans des conditions telles qu'il se forme une couche polycristalline dont la vitesse de croissance est de 10 à 50 nanomètres par seconde environ.

Le semi-conducteur peut être par exemple le germanium et le dopant l'aluminium.

Ces couches peuvent être utilisées comme couches absorbantes dans les capteurs solaires ou encore, par exemple, comme couches semi-réfléchissantes sur des parois en verre.

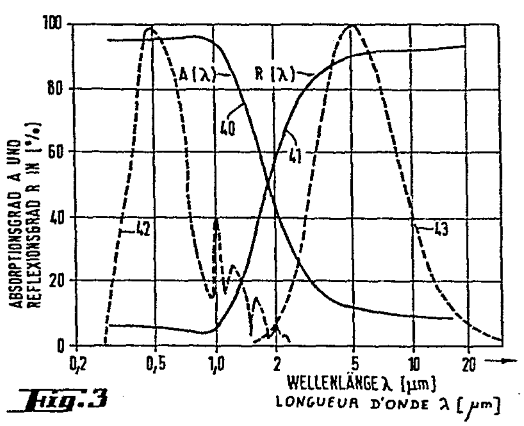

Fig.3

EP 0 093 672 A2

Croydon Printing Company Ltd.

# DEPOT SUR UN SUBSTRAT D'UNE COUCHE SEMI-CONDUCTRICE DOPEE AFIN DE CONSTITUER UNE COUCHE A REFLEXION SELECTIVE

La présente invention a trait à la formation sous vide de couches semi-conductrices dopées sur un substrat préalablement chauffé, soit par évaporation thermique, soit par pulvérisation cathodique simultanée d'un semi-conducteur et d'un dopant. Plus particulièrement, l'invention se rapporte à un procédé de fabrication de telles couches, à leur application ainsi qu'à un dispositif de mise en oeuvre du procédé.

On a déjà largement employé ce type de procédé pour déposer sur des substrats des couches appropriées aux objectifs les plus divers. Ainsi, on peut fabriquer par exemple des couches thermo ou photo-sensibles, des diodes, des couches transparentes conductrices de l'électricité, des couches photovoltaïques, etc...

L'invention se propose de perfectionner les procédés déjà existants, afin de permettre la fabrication de couches à réflexion sélective qui présentent une transition très nette entre le domaine de longueurs d'ondes où le facteur de réflexion est faible et celui où il est fort. On appellera, dans la suite de la description, longueur d'onde de coupure la longueur d'onde où s'amorce cette modification du facteur de réflexion de la couche, le facteur de réflexion étant défini comme le pourcentage de l'énergie incidente réfléchie par la couche.

Le procédé selon l'invention est remarquable notamment en ce qu'on maintient, au cours du dépôt, le substrat à une température comprise entre 150°C et 500°C environ, le semi-conducteur et le dopant sont présents dans des proportions en poids comprises entre 5/1 et 2/1, la vitesse d'évaporation ou de pulvérisation est réglée de façon telle qu'on forme une couche polycristalline ayant une épaisseur maximale de 500 nanomètres, une densité élevée de dislocations et de joints de grains, une dispersion quasi-atomique du dopant, avec une vitesse de croissance d'environ 10 à 50 nanomètres par seconde.

Selon une forme préférée de réalisation du procédé, on maintient le substrat entre 250°C et 300°C, on choisit un rapport pondéral du semi-conducteur au dopant entre 4,5/1 et 2,5/1, et des conditions de mise en oeuvre du procédé de façon à obtenir une vitesse de croissance de la couche comprise entre 20 et 30 nanomètres par seconde.

Grâce au procédé selon l'invention, on peut fabriquer des couches semi-conductrices dopées pour lesquelles le passage d'un facteur d'absorption élevé, dans le domaine visible du spectre, à une émissivité faible, dans le domaine de l'infra-rouge thermique (non solaire), c'est-à-dire correspondant à des longueurs d'onde supérieures à 2,5 µm environ, se fait de façon extrêmement brutale. Suivant le choix que l'on fait des conditions de mise en oeuvre du procédé, on peut jouer sur la longueur d'onde de coupure, telle qu'elle a été précédemment définie, ce qui peut être intéressant selon l'application envisagée.

Ainsi il est possible d'augmenter le dopage de la couche et par là même, du fait d'une densité plus importante de porteurs de charges libres, de décaler la coupure de plasma et donc aussi la transition considérée qui peut avoir lieu jusqu'à une longueur d'onde inférieure à 1 µm.

Ainsi, de façon quasi idéale, la couche semi-conductrice simultanément absorbe le rayonnement solaire sous forme d'énergie d'excitation électronique, et réfléchit le rayonnement thermique.

Le procédé selon l'invention permet en particulier d'introduire le dopant dans la couche semi-conductrice en le dispersant régulièrement de façon quasi-atomique, ce qui contribue à l'obtention de l'effet recherché. Une analyse aux rayons X de la structure fine de la couche révèle la structure polycristalline du semi-conducteur. On observe par ailleurs un fond continu peu important, ce qui indique clairement qu'on est en présence d'une très faible proportion de phase amorphe au milieu des cristallites. Il apparait donc clairement qu'avec les conditions du procédé selon l'invention, on obtient de façon remarquable la dispersion atomique souhaitée de l'élément dopant ainsi qu'une structure polycristalline de la couche semi-conductrice.

Le procédé selon l'invention est particulièrement avantageux lorsqu'on choisit comme semi-conducteur un élément covalent comme le silicium ou le germanium, et comme dopant un élément des colonnes III ou V du système périodique des éléments convenant pour un dopage p ou n. L'aluminium notamment s'est révélé particulièrement approprié pour le dopage p, et l'antimoine notamment pour le dopage n.

Selon une caractéristique de l'invention, on forme la couche semi-conductrice de façon contrôlée, en mesurant en continu au cours de sa formation les proportions respectives de semi-conducteur et de dopant en phase vapeur, par exemple par la spectrométrie de masse, et en utilisant les valeurs numériques ainsi obtenues pour régler en conséquence la puissance d'évaporation ou de pulvérisation. Au lieu d'utiliser la spectrométrie de masse, on peut aussi mesurer en continu la vitesse de croissance et la composition de la couche semi-conductrice en suivant les variations de fréquence de résonance d'un quartz piézoélectrique de référence, ou même de deux quartz, l'un en relation avec le semi-conducteur, l'autre avec le dopant, et utiliser ces valeurs pour régler en conséquence la puissance d'évaporation ou de pulvérisation.

Dans le cas où on forme la couche par évaporation, on peut procéder à une évaporation purement thermique, ou de préférence au moyen d'un faisceau électronique. Pour ce dernier procédé, il est souhaitable de maintenir une pression résiduelle de $10^{-6}$ à $10^{-5}$ mbar dans l'enceinte où a lieu le dépôt.

Dans le cas où on forme la couche par pulvérisation cathodique, on procède au dépôt dans une enceinte sous vide où l'on maintient une pression résiduelle de $10^{-3}$ à 10 mbar environ.

Pour obtenir une couche répartie le plus uniformément possible sur le substrat, tout en limitant le nombre de sources d'évaporation, il convient de mettre en rotation le substrat au cours du dépôt avec une vitesse suffisamment importante.

Selon une caractéristique avantageuse de l'invention, il est possible, après la formation de la couche semi-conductrice à réflexion sélective, de déposer par-dessus une couche anti-reflet. On peut de cette façon améliorer sensiblement les propriétés d'absorption de la couche. La couche anti-reflet améliore également la résistance à la corrosion de la couche semi-conductrice. En revanche, elle ne doit pas augmenter l'émissivité de la couche dans le domaine des grandes longueurs d'onde. On choisit l'épaisseur de la couche anti-reflet de façon à ce qu'elle soit égale au quart de la longueur d'onde correspondant au facteur de réflexion minimal de la couche semi-conductrice.

Il convient de déposer la couche anti-reflet par évaporation ou pulvérisation et cela peut être fait de façon appropriée dans la même enceinte à vide que pour le dépôt de la couche semi-conductrice.

De préférence, on choisit, pour constituer la couche anti-reflet, une combinaison ou un mélange d'oxydes ou de fluorures de terres rares. Cette couche est alors une couche diélectrique qui, tout en permettant d'augmenter le rendement du procédé, sert également à protéger la surface. On obtient ainsi un renforcement des propriétés mécaniques et chimiques de la couche, ce qui est important par exemple en cas de présence d'acide sulfureux.

Pour abaisser encore davantage, dans le domaine de longueurs d'onde situé en dessous de la longueur d'onde de coupure, les pertes déjà faibles d'énergie par réflexion on peut recouvrir la couche semi-conductrice d'une couche anti-reflet multiple au lieu d'une couche simple, ce qui permet d'étendre la zone de longueurs d'onde où les pertes par réflexion sont davantage réduites.

Selon une caractéristique supplémentaire de l'invention, on peut après le dépôt de la couche anti-reflet, procéder à un recuit de plusieurs heures du substrat ainsi recouvert, à une température comprise entre 250°C et 500°C environ. Le recuit a lieu de préférence sous un vide poussé, afin d'améliorer encore la sélectivité et par là le rendement du procédé. On peut toutefois également obtenir une telle amélioration par un recuit sous pression normale à condition de procéder sous atmosphère contrôlée, par exemple dans un gaz inerte ou un gaz rare.

Les couches déposées par le procédé selon l'invention, avec les propriétés spécifiques qui leur sont ainsi conférées, sont particulièrement intéressantes comme absorbeurs pour les capteurs solaires. Dans cette application, en particulier en ce qui concerne la température de travail, les couches, lorsqu'elles sont optimisées, permettent d'obtenir des rendements qu'il était impossible d'obtenir auparavant avec d'autres couches du même genre fabriquées selon les procédés usuels. Le rendement est très proche du rendement théorique.

En faisant varier la quantité de dopant intervenant dans le procédé, on peut décaler la longueur d'onde de coupure, afin d'optimiser le procédé à la température de travail du capteur. On maintient une absorption pratiquement totale dans le domaine visible du spectre. Le passage d'une forte absorption à une forte réflexion a lieu à la longueur d'onde souhaitée, en particulier quand la température de travail du capteur est élevée. On peut ainsi atteindre une température finale élevée sans concentration du rayonnement solaire par des moyens supplémentaires. Simultanément on obtient une stabilité suffisante à long terme. Pour des températures plus basses, on observe une amélioration considérable du rendement.

Ainsi par exemple, les absorbeurs fabriqués par le procédé selon l'invention et qui possèdent une longueur d'onde de coupure de 1,8 µm, présentent lorsque la paroi du capteur est perpendiculaire au rayonnement solaire, un facteur d'absorption pouvant aller jusqu'à 95 %, tandis que l'émission à une température de 280°C environ, ne s'élève qu'à 8 - 10 %. La sélectivité susceptible d'être atteinte dépasse par conséquent 10. En outre, il résulte des faibles épaisseurs de couche nécessaires, en dessous de 1 micron, de très faibles coûts de matières premières.

Les couches fabriquées par le procédé selon l'invention peuvent trouver une application également dans d'autres domaines. Par exemple, on peut déposer de telles couches sous une forme très mince et transparente sur des feuilles de verre, et utiliser ces feuilles de verre recouvertes de couches minces pour constituer des vitrages, notamment de véhicules, par exemple de véhicules automobiles. Des feuilles de verre ainsi recouvertes, pour lesquelles la coupure de plasma est très nette peuvent à la fois, de façon tout à fait remarquable, servir de vitrages anti-chaleur contre l'énergie solaire, et présenter simultanément la propriété de réfléchir vers l'intérieur de l'habitacle des véhicules les rayonnements situés dans les grandes longueurs d'onde émis par les objets et parois intérieures échauffés. Un tel vitrage est utile aussi bien pour les périodes chaudes que pour les périodes fraiches de l'année.

Suivant les cas d'application envisagés, le substrat sur lequel s'effectue le dépôt des couches peut être très varié, à condition de s'assurer qu'il résiste aux températures qui sont celles du dépôt de la couche ou de son utilisation. Ainsi, on peut envisager comme matériaux convenant pour l'invention, outre des métaux et du verre, des matières plastiques ayant les propriétés requises.

D'autres caractéristiques et avantages de l'invention apparaitront au cours de la description suivante, qui indique différents exemples de réalisation de l'invention en relation avec les planches de dessins annexées sur lesquelles :

- la figure 1 représente de façon schématique un dispositif selon l'invention pour former une couche semi-conductrice par évaporation thermique,

- la figure 2 représente, également de façon schématique, un dispositif conçu selon l'invention pour former une couche semi-conductrice par pulvérisation cathodique,

- la figure 3 représente, en fonction de la longueur d'onde $\lambda$ le facteur de réflexion R et d'absorption A d'une couche fabriquée selon l'invention,

- la figure 4 illustre par une courbe le rendement utile d'un absorbeur selon l'invention et celui d'un absorbeur noir,

- la figure 5 illustre par une courbe l'évolution en fonction du temps de la température d'un absorbeur selon l'invention en comparaison avec un absorbeur noir.

Le dispositif représenté à la figure 1 et conçu pour la mise en oeuvre du procédé selon l'invention, comprend une enceinte sous vide poussé 1, dans laquelle se trouvent une plaque chauffante 2 et/ou deux radiateurs 3. Ces éléments de chauffage 2 et 3 servent à préchauffer le substrat 4 à la température souhaitée, et à le maintenir à cette température au cours de la formation de la couche. Le substrat 4 est placé sur un support 10 mobile en rotation autour d'un axe 11. La température de la plaque chauffante 2 et celle des radiateurs 3 sont régulées au moyen d'un dispositif thermoélectrique en fonction de la température de surface du substrat 4. Afin de ne pas surcharger la figure, les dispositifs de régulation de la température ne sont pas représentés.

Plusieurs creusets 5 d'évaporation du semi-conducteur et plusieurs creusets 6 d'évaporation du dopant sont répartis à l'intérieur de l'enceinte 1. On y trouve également des creusets d'évaporation 7 et 8 pour la formation de la couche anti-reflet. Le dispositif comprend en outre un système de dosage de gaz avec un tuyau 9 d'amenée de gaz dans l'enceinte 1.

On préchauffe le semi-conducteur dans le creuset d'évaporation 5 d'une part, et le dopant dans le creuset d'évaporation 6 d'autre part, à la température nécessaire à l'évaporation grâce respectivement aux éléments 12 et 13 de chauffage électrique. Il est également possible d'employer comme éléments de chauffage 12 et 13 des canons à électrons qui dirigent le faisceau électronique directement sur la matière à évaporer. Par ailleurs, l'élément de chauffage électrique 14 sert à porter le matériau qui formera la couche anti-reflet à la température d'évaporation.

On fait pénétrer dans l'enceinte 1 la sonde 16 d'un spectromètre de masse 18, grâce auquel on mesure en continu pendant le dépôt la composition de la phase vapeur. Les valeurs numériques communiquées par le spectromètre de masse 18 sont transmises au régulateur 20 par la connexion électrique 19. Le régulateur 20 pilote indépendamment l'un de l'autre les éléments de chauffage 12 et 13 par la connexion 21 en fonction des valeurs qui lui sont transmises, de sorte qu'il est possible de modifier non seulement la vitesse globale d'évaporation, mais également celle de l'un ou de l'autre des matériaux contenus dans les creusets 5 ou 6. Par la connexion 23 on commande l'élément de chauffage 14 qui permet de porter à leur température d'évaporation les matières contenues dans les creusets 7 et 8 et destinées à former la couche anti-reflet.

Le dispositif représenté de façon également schématique à la figure 2 est conçu pour mettre en oeuvre le procédé selon l'invention par pulvérisation cathodique. Dans ce cas, la plaque chauffante 26 disposée à l'intérieur de l'enceinte sous vide poussé 25, et qui permet de porter le substrat 27 à la température convenant pour le dépôt des couches, fait en outre office d'anode et est reliée par le fil 28 au pôle positif d'un générateur haute tension 30. Le substrat 27 fait lui-même directement office d'anode par l'intermédiaire du fil 29. La cathode est constituée par la plaque 32 qui est reliée au pôle négatif du générateur haute tension 30 par le fil 33. Les éléments constitutifs de la couche, à savoir le semi-conducteur 5 et le dopant 6 sont placés sur cette cathode 32 dans l'état approprié. La canalisation 9 de gaz est comme précédemment connectée à un dispositif de dosage de gaz et sert à remplir l'enceinte 25 d'un gaz adéquat, par exemple nécessaire à l'accomplissement d'une opération de recuit après le dépôt.

On place entre le substrat 27 et la cathode 32 un quartz piézoélectrique 34 sur lequel se dépose une couche comme sur le substrat 27. Du fait de la croissance d'une couche semi-conductrice sur sa surface, le quartz 34 voit sa fréquence de résonance se modifier ; on peut ainsi mesurer en continu la vitesse de croissance de la couche semi-conductrice d'après la dérive de la fréquence de résonance du quartz.

Le traitement des signaux a lieu dans l'analyseur 35, qui commande le régulateur 37 par la connexion 36. Le régulateur 37 pilote lui-même le générateur haute fréquence 30 grâce à la connexion 38, la tension de sortie du générateur étant réglée de telle façon qu'elle affiche une valeur convenant pour la vitesse de croissance souhaitée de la couche semi-conductrice sur le substrat.

Bien que la figure 2 ne représente qu'un seul quartz piézoélectrique complété d'appareils de mesures et de réglage, l'invention peut également être exécutée selon une forme particulièrement avantageuse avec deux quartz piézoélectriques et les appareils correspondants de mesures et de réglage. Dans ce cas, les deux quartz et les appareils correspondants concernent respectivement la vitesse de pulvérisation du semi-conducteur et celle du dopant. On peut, en procédant ainsi, mesurer séparément les quantités de chaque composant, et régler séparément les vitesses de pulvérisation correspondantes.

L'exemple suivant de fabrication d'une plaque recouverte d'une couche à réflexion sélective afin de constituer un absorbeur sera décrit en référence avec la figure 1.

Le substrat est une plaque de tôle 4 en acier chrome-vanadium (115 Cr V 3). Avant de l'introduire dans l'enceinte 1, on nettoie minutieusement la face sur laquelle s'effectuera le dépôt. Puis on le fixe sur le support pivotant 10.

Le semi-conducteur employé est le germanium, et le dopant l'aluminium, dans un rapport en poids germanium/aluminium de 4,3/1. On introduit séparément les deux éléments dans des creusets 5 et 6 en tungstène et on place les creusets à une distance de 20 cm environ de la face du substrat à recouvrir, au dessus des éléments de chauffage 12 et 13 réglables individuellement.

On maintient l'enceinte 1 sous une pression résiduelle de $3.10^{-5}$ mbar au cours de l'évaporation. Grâce aux plaques chauffantes 2 et/ou au radiateur 3, on porte le substrat à 290° C et on régule à cette température par thermocouples interposés. C'est alors que l'on met en rotation le support 10. On branche ensuite les éléments de chauffage 12 et 13, en leur donnant une puissance telle qu'il se forme sur le substrat 5 une couche semi-conductrice à une vitesse de 30 nanomètres par seconde. Au bout de 30 secondes, on supprime l'alimentation électrique des éléments de chauffage 12 et 13. Il s'est alors formé une couche de 295 nanomètres d'épaisseur.

On mesure la vitesse de croissance de la couche à l'aide du spectromètre de masse 16, 18. A cette fin, on mesure en premier lieu la masse de l'isotope 72 du germanium ainsi que celle de l'isotope 27 de l'aluminium correspondant à la vitesse de croissance désirée de 30 nanomètres par seconde et on programme cette valeur dans le spectromètre 18. Au cours de la phase d'évaporation, le spectromètre 18 commande le régulateur 20 de façon à ce que les quantités respectives de germanium et d'aluminium préalablement programmées dans le spectromètre soient toujours respectées. De ce fait, on applique sur le substrat 4, chauffé en conséquence, les deux matériaux dans les proportions préalablement déterminées.

Après avoir débranché les éléments de chauffage 12 et 13, on débranche la plaque chauffante 2 et les radiateurs 3. Puis, lorsque le substrat 4 a pratiquement atteint la température ambiante, on branche l'élément de chauffage 14 à l'aide duquel on évapore $CeO_2$ dans les creusets d'évaporation 7 et 8. On choisit les quantités d'oxyde de cerium ($CeO_2$) de façon telle, qu'après évaporation complète, il se soit formé une couche anti-reflet de 0,063 µm d'épaisseur environ.

Ensuite, on procède au recuit du substrat enduit des couches formées selon l'invention, dans l'enceinte 1, pendant une heure, à une température de 250°C sous vide. On aère alors l'enceinte 1 et on en retire le substrat.

Le diagramme de la figure 3 illustre les propriétés spectrophotométriques de la couche obtenue. La courbe 40 représente le facteur d'absorption A, la courbe 41 le facteur de réflexion R de la couche, en fonction de la longueur d'onde. On s'aperçoit que, jusqu'à une longueur d'onde de 1 µm environ, environ 95 % du rayonnement est absorbé, et que cette valeur chute brutalement, entre 1 et 3 µm pour atteindre 10 %. Au contraire, le pouvoir réfléchissant de la couche qui n'est que de 5 % environ au dessous de 1 µm s'élève brutalement entre 1 et 3 µm pour atteindre 90 % environ.

Il apparait donc clairement que cette couche remplit dans une large mesure les conditions suivantes qui sont celles du fonctionnement idéal d'un absorbeur du rayonnement solaire par effet photothermique : absorber le plus possible le rayonnement solaire qui tombe à la surface de la terre après avoir été modifié par la traversée de l'atmosphère, et dont l'énergie maximale correspond dans le spectre à une longueur d'onde de 0,55 µm, et d'autre part empêcher que l'énergie absorbée par la couche ne soit perdue du fait d'une émission propre dans les grandes longueurs d'onde à la suite d'une élévation de température.

Toujours dans la figure 3, les courbes 42 et 43 illustrent bien l'efficacité de la couche selon l'invention. La couche 42 représente, toujours en fonction de la longueur d'onde, la répartition énergétique du rayonnement solaire direct, et la couche 43 la répartition énergétique du rayonnement thermique émis par une paroi dont la température est de 300°C. Puisque justement, dans le domaine des grandes longueurs d'onde où le rayonnement thermique de la paroi est important, le facteur de réflexion de la couche est très élevé, alors les pertes par rayonnement sont réduites à un minimum, car il est bien connu qu'à un pouvoir réfléchissant important correspond une émissivité faible.

Le rendement d'un absorbeur sélectif tel que nous l'avons décrit est donc toujours beaucoup plus élevé que dans celui d'un absorbeur noir. Pour illustrer cette propriété, la figure 4 représente un diagramme dans lequel la couche 44 et la courbe 45 expriment, en fonction de la température de travail de l'absorbeur, pour une énergie solaire rayonnée de 1 $kW/m^2$, d'une part le rendement d'une couche absorbante selon l'invention et d'autre part, celui d'un absorbeur noir. On s'aperçoit que, quelle que soit la température de travail que l'on peut déterminer de façon connue d'après la quantité de chaleur éliminée par un échangeur de chaleur, le rendement est beaucoup plus élevé dans le cas de la couche selon l'invention que dans celui d'un absorbeur noir. Alors que, par exemple, à une température de travail de 200°C, l'absorbeur selon l'invention a un rendement de 50 %, un absorbeur noir présente, à une température de 120°C, qui correspond à la température maximale qu'il puisse atteindre sous l'effet du rayonnement solaire, et à condition de s'être affranchi totalement des pertes thermiques par conduction ou convection, un rendement pratiquement nul.

Le diagramme de la figure 5 représente par les courbes 46 et 47 l'évolution en fonction du temps de la température, d'une part d'un absorbeur selon l'invention, et d'autre part d'un absorbeur noir lorsqu'on fixe les conditions suivantes : au temps $t_0$, on fournit une énergie de 1 $kW/m^2$, et au temps $t_1$, on la supprime.

On observe très nettement, à la lecture de ces courbes, un échauffement beaucoup plus rapide de l'absorbeur selon l'invention pendant un temps donné, ainsi qu'un refroidissement beaucoup plus lent après la suppression de la source énergétique. Dans les deux cas, on a procédé aux mesures sur les absorbeurs, sous un vide poussé, sans qu'il y ait de pertes thermiques par conduction ou convection.

REVENDICATIONS

1. Procédé de formation d'une couche semi-conductrice dopée sur un substrat préalablement chauffé, dans une enceinte sous vide poussé, dans lequel, on évapore thermiquement ou on pulvérise simultanément un semi-conducteur et un dopant, caractérisé en ce que pendant la formation de la couche on maintient le substrat à une température comprise entre 150°C et 500°C environ, le semi-conducteur et le dopant sont présents dans des proportions en poids comprises entre 5/1 et 2/1, on règle la puissance d'évaporation ou de pulvérisation de façon telle qu'il se forme une couche polycristalline d'une épaisseur maximale de 500 nanomètres environ, présentant une densité élevée de dislocations et de joints de grains, ainsi qu'une dispersion quasi-atomique du dopant, avec une vitesse de croissance comprise entre 10 et 50 nanomètres par seconde environ.

2. Procédé selon la revendication 1, caractérisé en ce que pendant la formation de la couche on maintient le substrat à une température comprise entre 250°C et 300°C, le semi-conducteur et le dopant sont présents dans des proportions en poids comprises entre 4,5/1 et 2,5/1, et on fait croître la couche à une vitesse de 20 à 30 nanomètres par seconde.

3. Procédé selon la revendication 1 ou la revendication 2, caractérisé en ce que le semi-conducteur est un semi-conducteur covalent et le dopant est un des éléments des colonnes III et V de la classification périodique des éléments permettant de réaliser un dopage p ou n.

4. Procédé selon la revendication 3, caractérisé en ce que le semi-conducteur est le germanium et le dopant l'aluminium.

5. Procédé selon l'une des revendications 1 à 4, caractérisé en ce que au cours de la formation de la couche on mesure les proportions respectives de semi-conducteur et de dopant présentes dans la phase vapeur, à l'aide d'un spectromètre de masse, et on utilise les valeurs obtenues pour régler en conséquence la puissance des dispositifs d'évaporation ou de pulvérisation.

6. Procédé selon l'une des revendications 1 à 5, caractérisé en ce qu'on suit en continu la vitesse de croissance de la couche sur le substrat en notant les variations de la fréquence de résonance d'un quartz piézoélectrique sur lequel une même couche se dépose simultanément, les valeurs obtenues servant à régler en conséquence la puissance des dispositifs d'évaporation ou de pulvérisation.

7. Procédé selon l'une des revendications 1 à 6, caractérisé en ce que le dépôt se fait par évaporation thermique à une pression de $10^{-6}$ à $10^{-5}$ mbar.

8. Procédé selon l'une des revendications 1 à 6, caractérisé en ce que le dépôt se fait par pulvérisation cathodique des produits de départ à une pression de $10^{-3}$ à 10 mbar.

9. Procédé selon l'une des revendications 1 à 8, caractérisé en ce qu'on dépose une couche anti-reflet sur la couche à réflexion sélective déjà formée.

10. Procédé selon la revendication 9, caractérisé en ce qu'on dépose la couche anti-reflet par évaporation thermique.

11. Procédé selon l'une des revendications 9 ou 10, caractérisé en ce qu'on forme la couche anti-reflet à partir d'une combinaison ou d'un mélange d'oxydes ou de fluorures de terres rares.

12. Procédé selon la revendication 11, caractérisé en ce qu'on forme la couche anti-reflet à partir d'oxyde de cerium.

13. Procédé selon l'une des revendications 9 à 12, caractérisé en ce qu'on forme une couche anti-reflet d'une épaisseur égale au quart de la longueur d'onde correspondant au facteur de réflexion minimal de la couche semi-conductrice.

14. Procédé selon l'une des revendications 9 à 13, caractérisé en ce qu'on dépose sur la couche à absorption sélective déjà formée un couche multiple anti-reflet.

15. Procédé selon l'une des revendications 1 à 14, caractérisé en ce qu'après le dépôt de la ou des couche (s) on procède à un recuit à une température comprise entre 250°C et 500°C.

16. Procédé selon la revendication 15, caractérisé en ce que le recuit a lieu sous vide poussé.

17. Procédé selon la revendication 15, caractérisé en ce que le recuit a lieu sous pression normale dans une atmosphère gazeuse.

18. Application du procédé selon l'une quelconque des revendications 1 à 17 à la fabrication de couches absorbantes pour les capteurs solaires.

19. Application du procédé selon l'une des revendications 1 à 17 à la formation de couches minces transparentes à réflexion sélective sur des surfaces de verre.

20. Dispositif pour la mise en oeuvre du procédé selon l'une des revendications 1 à 8 à l'intérieur d'une enceinte sous vide poussé, dans laquelle se trouve un système de chauffage réglable en température pour chauffer le substrat ainsi que divers dispositifs permettant de réaliser une évaporation thermique ou une pulvérisation cathodique, caractérisé en ce que l'enceinte sous vide comprend également un dispositif de mesure de la vitesse de croissance de la couche semi-conductrice ou de la concentration et/ou des proportions en phase vapeur des différents composants qui vont constituer la couche, ainsi qu'un dispositif de pilotage de la puissance d'évaporation ou de pulvérisation des produits de départ d'après les valeurs mesurées.

21. Dispositif selon la revendication 20, caractérisé en ce que le dispositif de mesure est un spectromètre de masse.

22. Dispositif selon la revendication 20, caractérisé en ce que le dispositif de mesure comprend un quartz piézoélectrique et un montage électronique de mesure de la fréquence de résonance du quartz.

23. Dispositif selon la revendication 20, caractérisé en ce que le dispositif de mesure comprend deux quartz piézoélectriques et deux montages électroniques de mesure de la fréquence de résonance du quartz coordonnés respectivement au semi-conducteur et au dopant.

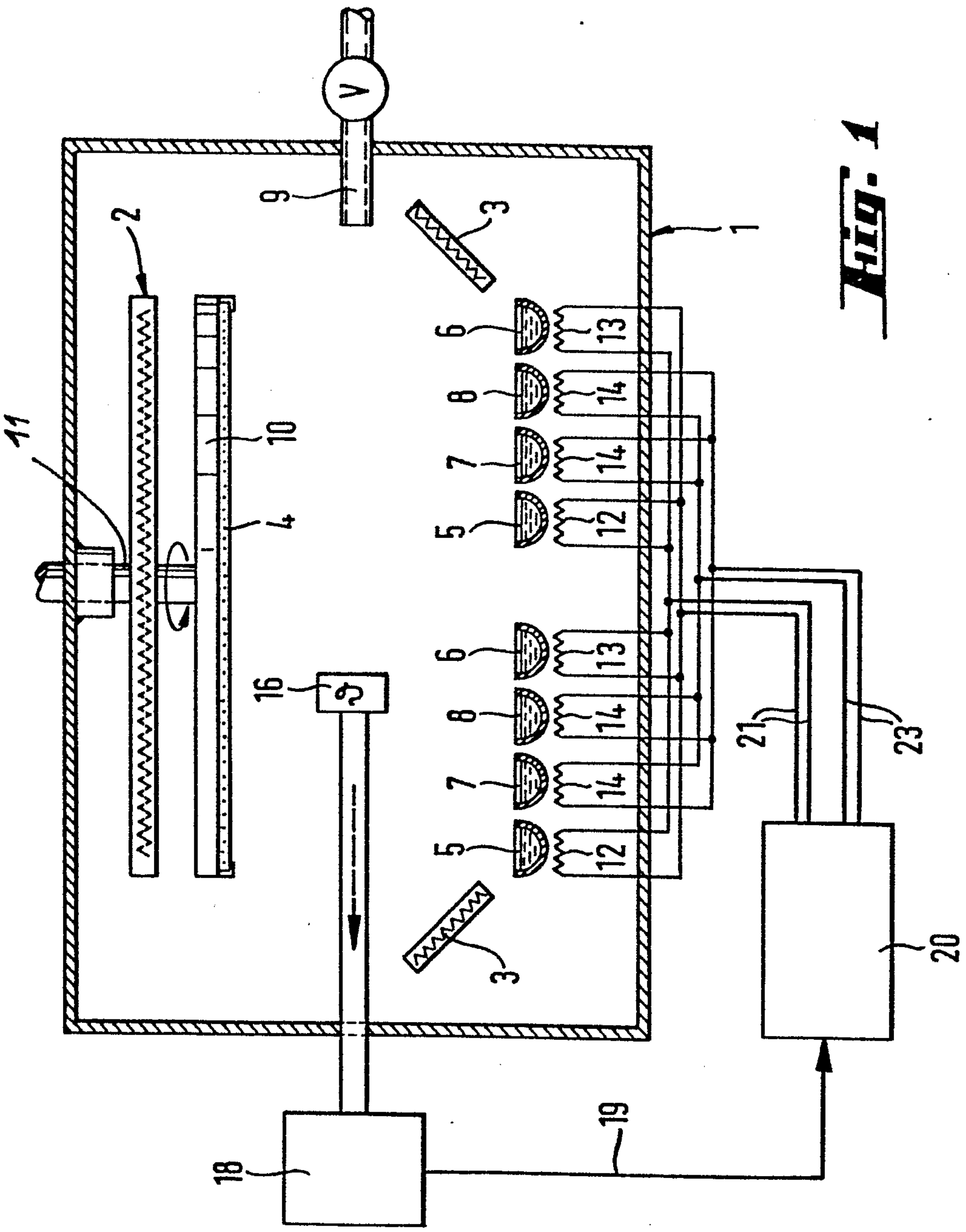

Fig. 1

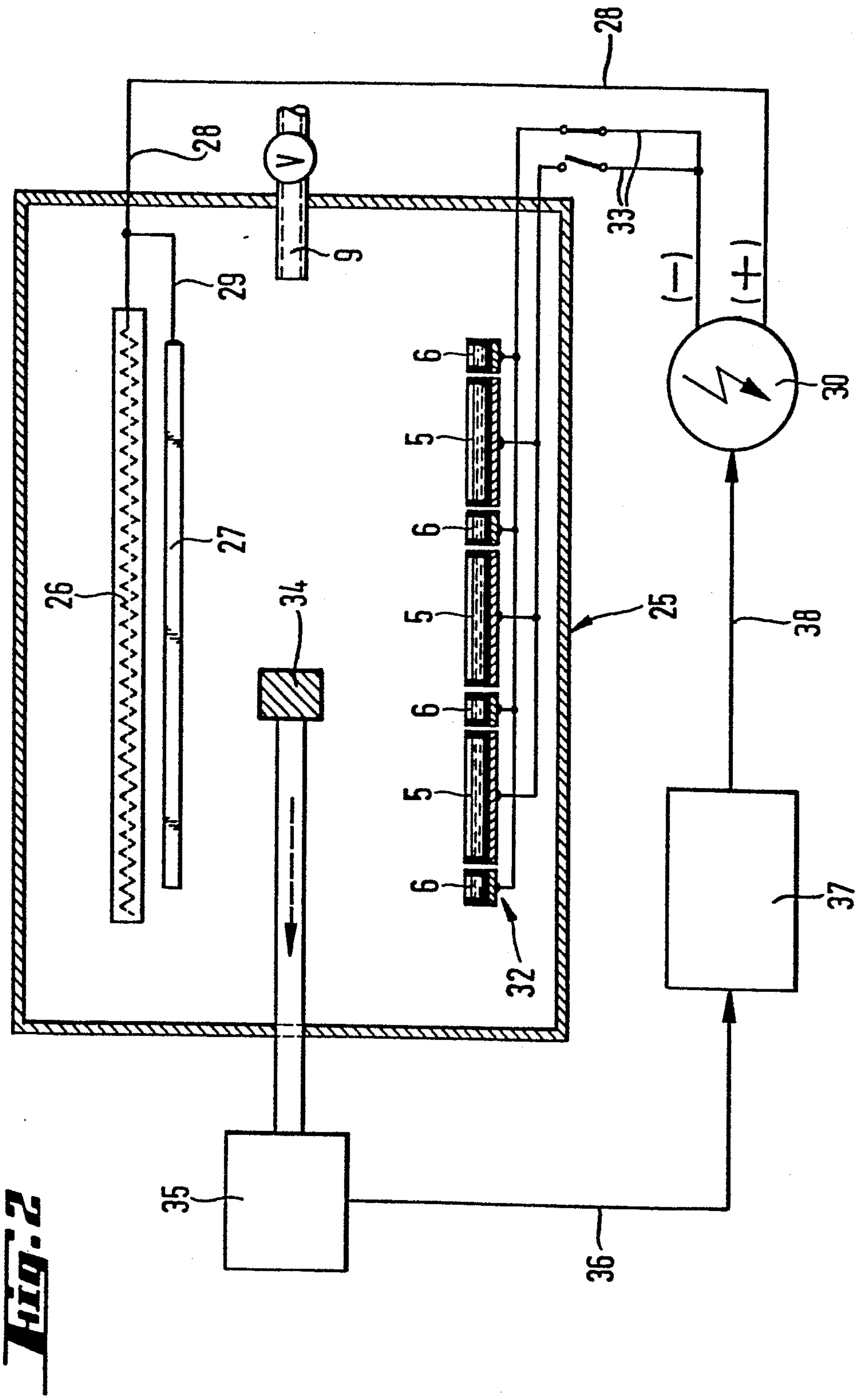


Fig. 2

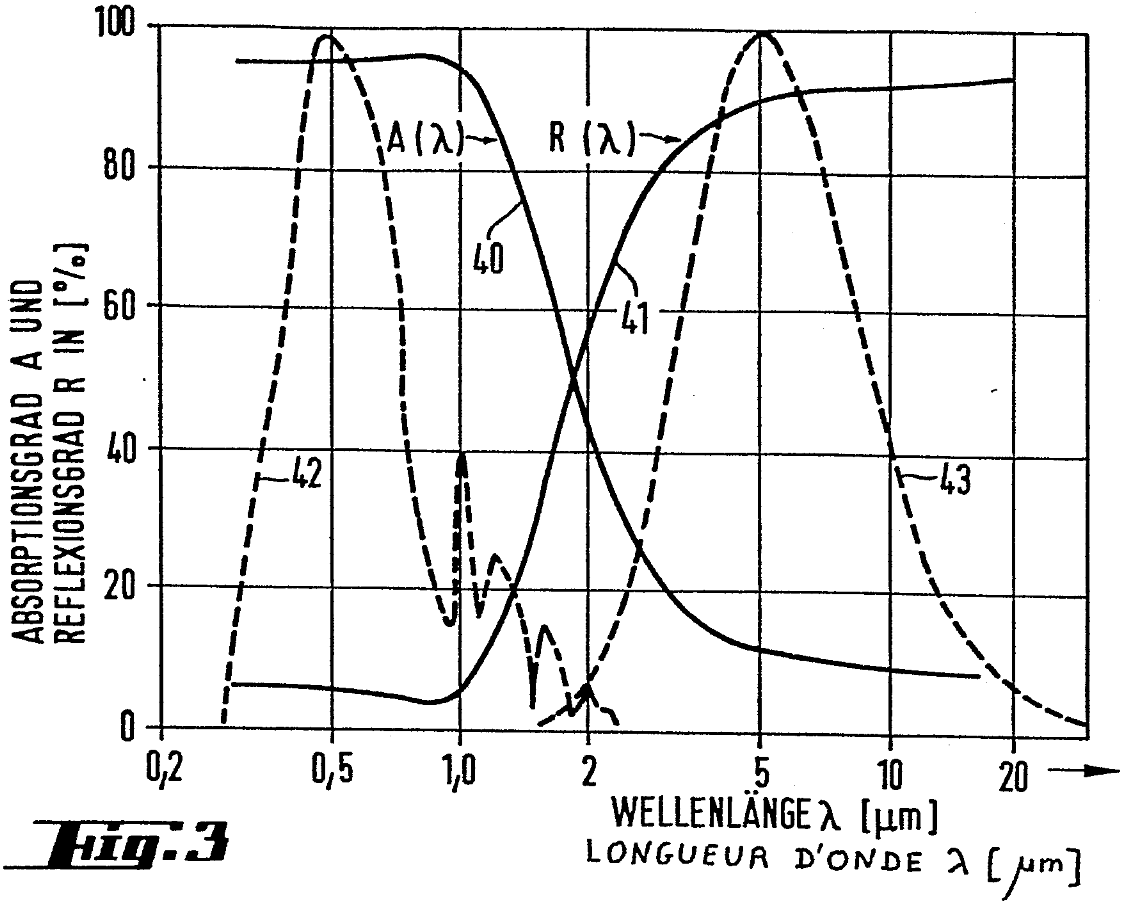
100
80
60
40
20
0
ABSORPTIONSGRAD A UND
REFLEXIONSGRAD R IN [%]
A (λ)
R (λ)
40
41
42
43
0,2
0,5
1,0
2
5
10
20
WELLENLÄNGE λ [μm]
LONGUEUR D'ONDE λ [μm]

Fig. 3

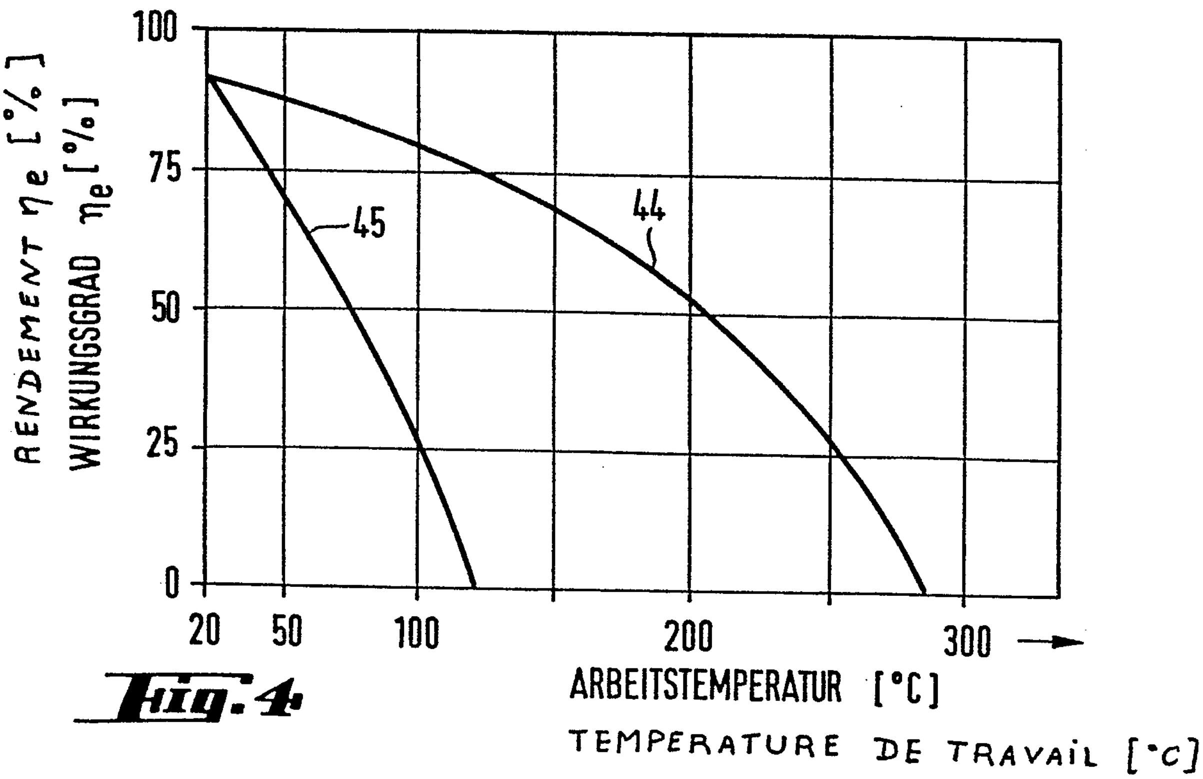
100
75
50
25
0
RENDEMENT ηe [%]
WIRKUNGSGRAD ηe [%]
45
44
20
50
100
200
300
ARBEITSTEMPERATUR [°C]
TEMPERATURE DE TRAVAIL [°C]

Fig. 4

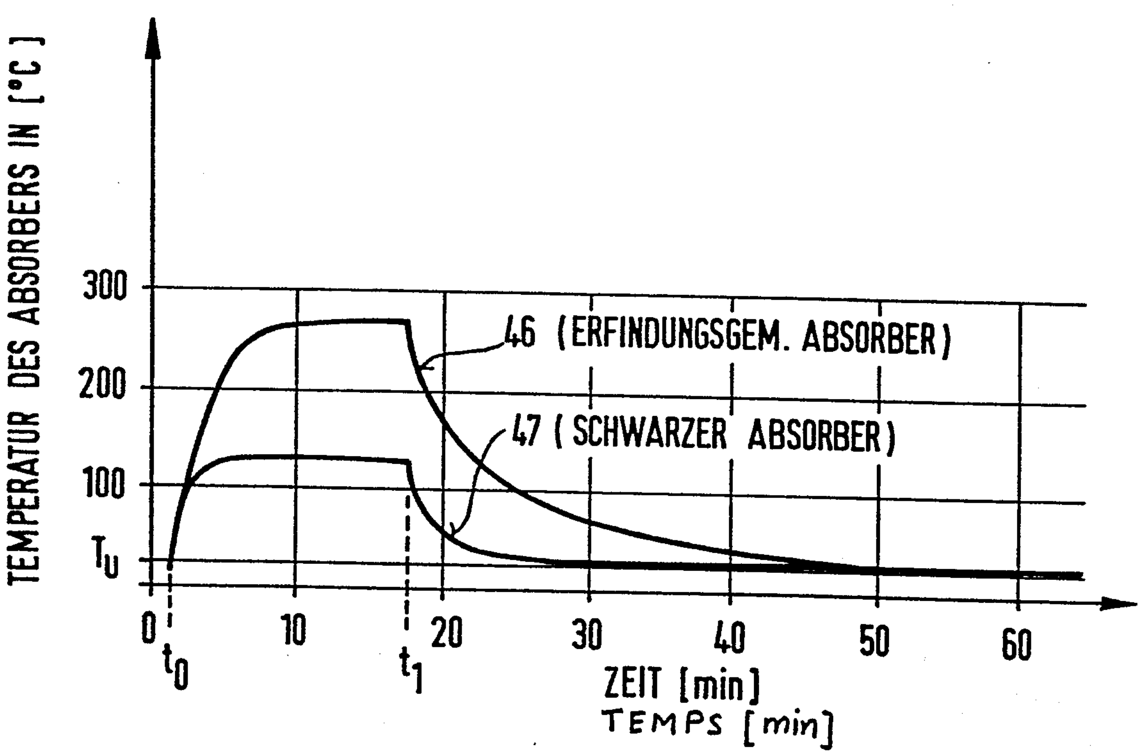
TEMPERATUR DES ABSORBERS IN [°C]
300
200
100
$T_U$
46 (ERFINDUNGSGEM. ABSORBER)
47 (SCHWARZER ABSORBER)
0
10
20
30
40
50
60
$t_0$
$t_1$
ZEIT [min]
TEMPS [min]

Fig. 5